**Europäisches Patentamt**

**European Patent Office**

**Office européen des brevets**

(19)

(11) Veröffentlichungsnummer: **0 309 888 B1**

(12) **EUROPÄISCHE PATENTSCHRIFT**

(45) Veröffentlichungstag der Patentschrift: **31.03.93**

(51) Int. Cl.5: **H04B 3/23**, H04L 25/03, G06F 15/336

(21) Anmeldenummer: **88115487.6**

(22) Anmeldetag: **21.09.88**

(54) **Verfahren und Schaltungsanordnung zur Erzeugung von Filtersignalen.**

(30) Priorität: **30.09.87 DE 3733043**

(43) Veröffentlichungstag der Anmeldung:
**05.04.89 Patentblatt 89/14**

(45) Bekanntmachung des Hinweises auf die Patenterteilung:
**31.03.93 Patentblatt 93/13**

(84) Benannte Vertragsstaaten:
**AT BE CH DE FR GB IT LI NL SE**

(56) Entgegenhaltungen:
**EP-A- 0 145 022**
**US-A- 4 121 296**

(73) Patentinhaber: **SIEMENS AKTIENGESELL-SCHAFT**
**Wittelsbacherplatz 2**
**W-8000 München 2(DE)**

(72) Erfinder: **Schenk, Heinrich, Dr. Ing.**
**Becker-Gundahl-Strasse 1**
**W-8000 München 71(DE)**

**Beschreibung**

Die Erfindung betrifft ein Verfahren und eine Schaltungsanordnung zur Erzeugung von Filtersignalen gemäß Oberbegriff des Patentanspruches 1.

Beispielsweise sind für eine Duplex-Übertragung von Datensignalen im Gleichlageverfahren über eine Zweidraht-Leitung Signalübertragungseinrichtungen vorgesehen, welche über eine Sendeeinrichtung und eine Empfangseinrichtung verfügen. Bei der Abgabe von Datensignalen von der Sendeeinrichtung her an die ZweidrahtLeitung treten in der zugehörigen Empfangseinrichtung sogenannte Echosignale auf, die den eigentlich empfangenen Datensignalen überlagert sind. Diese Echosignale können dabei wesentlich größer sein als die empfangenen Datensignale. Für die Kompensation derartiger Echosignale ist ein Echokompensator vorgesehen, der den Echosignalen entsprechende Korrektursignale erzeugt, welche von dem aus Echosignalen und empfangenen Datensignalen bestehenden Signalgemisch subtrahiert werden.

Für die Erzeugung von Korrektursignalen werden üblicherweise Anordnungen nach Art eines Transversalfilters benutzt. Bei bekannten Ausführungen derartiger Transversalfilter werden, wie beispielsweise aus der Zeitschrift "telcom report", 2 (1979), Heft 6, Seiten 413 bis 417 hervorgeht, für die Übertragung von Datensignalen, die eine Mehrzahl von unterschiedlichen Amplitudenwerten annehmen können, N aufeinanderfolgende Datensignale in einer Durchlauf-Speicheranordnung gespeichert. Die Amplitudenwerte der in dieser Durchlauf-Speicheranordnung gespeicherten Datensignale werden in einem der Übertragungsgeschwindigkeit der Datensignale entsprechenden Zeitraster nacheinander mit Hilfe eines Multiplizierers mit Korrektursignal-Koeffizienten multipliziert. Die daraus resultierenden Produktsignale werden anschließend zu einem Summensignal zusammengefaßt.

Dieses Summensignal stellt ein Korrektursignal dar, mit dem ein in der Empfangseinrichtung einer Signalübertragungseinrichtung gerade auftretendes Echosignal kompensiert wird. Bei der Verwendung eines einzigen Multiplizierers ist somit in einem der Übertragungsgeschwindigkeit der Datensignale entsprechenden Zeitraster in Abhängigkeit von der Anzahl der für die Bildung eines Korrektursignals zu berücksichtigenden aufeinanderfolgenden Datensignale gegebenenfalls nacheinander eine Vielzahl von Multiplikationen durchzuführen. Beispielsweise wären bei einer Datensignal-Übertragungsgeschwindigkeit von 80 kBaud und einer Einbeziehung von 48 aufeinanderfolgenden in die Bildung eines Korrektursignals in einer Zeitspanne von 12,5 $\mu$s nacheinander 48 Multiplikationen erforderlich. Dies kann je nach der Realisierung des betreffenden Multiplizierers zu Zeitproblemen führen, insbesondere, wenn noch höhere Übertragungsgeschwindigkeiten für die Übertragung von Datensignalen gewünscht sind.

Darüber hinaus ist bereits eine digitale Signalverarbeitungsanordnung für die Erzeugung von digitalen Ausgangssignalwerten bekannt (US-PS 4 121 296). Bei dieser Anordnung werden nach Maßgabe von in einer Speicheranordnung gespeicherten Eingangssignalwerten x (n), welche Amplituden $0, \pm A1, \pm A2,..., \pm AM$ annehmen können, zunächst für die M möglichen Amplitudenwerte individuell in Frage kommende Koeffizienten jeweils multipliziert mit dem Vorzeichen des Amplitudenwertes aufsummiert und M entsprechende Teilsummensignale bereitgestellt. Die Teilsummensignale werden anschließend jeweils mit einem dem jeweiligen Amplitudenwert entsprechenden Faktor multipliziert und die daraus resulierenden Produktsignale zu einem Summensignal aufsummiert. Mit dieser bekannten Anordnung sind lediglich symmetrischen Eingangssignalen entsprechende Ausgangssignale erzeugbar.

Es ist Aufgabe der vorliegenden Erfindung, einen Weg zu zeigen, wie bei einem Verfahren und einer Schaltungsanordnung der eingans genannten Art Unsymmetrien in den Eingangssignalen bei der Bildung der Filtersignale berücksichtigt werden können.

Gelöst wird die vorstehend aufgezeigte Aufgabe bei einem Verfahren der eingangs genannten Art durch die im kennzeichnenden Teil des Patentanspruches 1 angegebenen Verfahrensschritte.

Die Erfindung bringt den Vorteil mit sich, daß mit einer insgesamt geringen Anzahl von Verfahrensschritten Filtersignale für Eingangssignale gebildet werden können, deren mögliche Amplitudenstufen zumindest zum Teil durch Unsymmetrien von vorgegebenen Amplitudenwerten abweichen. So ist in einem der Übertragungsgeschwindigkeit der Datensignale entsprechenden Zeitraster lediglich einer der Anzahl der möglichen Amplitudenstufen und der Anzahl der durch Unsymmetrien von einem vorgegebenen Sollwert abweichenden Amplitudenwerte entsprechende Anzahl von Multiplikationen durchzuführen. Derartige Unsymmetrien in den Eingangssignalen können beispielsweise, insbesondere bei mehrwertigen Signalen, durch Bauelemente-Toleranzen in den der Filteranordnung vorgeschalteten Schaltungsanordnungen bedingt sein.

Vorteilhafte Ausgestaltungen des Verfahrens gemäß der vorliegenden Erfindung ergeben sich aus den Patentansprüchen 2 und 3. Der Vorteil dieser Ausgestaltungen besteht darin, daß durch eine adaptive Einstellung der für die Berücksichtigung von Unsymmetrien in den Eingangssignalen vorgesehenen Zusatz-Korrektursignal-Koeffizienten die Filteranordnung sich an unterschiedliche Unsymmetrien angepaßt. So ist es beispielsweise möglich, bei einer Übertragung von mehrwertigen Digitalsignalen Filtersignale zu erzeugen, um von einer Signalübertragungseinrichtung hervorgerufene unsymmetrischen Echosignalen zu kompensieren.

Eine Schaltungsanordnung gemäß der vorliegenden Erfindung und deren vorteilhafte Ausgestaltungen ergeben sich aus den Patentansprüchen 4 bis 8. Der Vorteil dieser Schaltungsanordnung besteht darin, daß für die Erzeugung von Korrektursignalen lediglich ein relativ geringer schaltungstechnischer Aufwand erforderlich ist.

Anhand von Zeichnungen wird die Erfindung nachstehend beispielsweise näher erläutert.

FIG 1 zeigt in einem Blockschaltbild eine Schaltungsanordnung gemäß der vorliegenden Erfindung.

FIG 2 zeigt eine Erweiterung der in FIG 1 dargestellten Schaltungsanordnung für die Erzeugung von der Kompensation unsymmetrischer Echosignale dienenden Korrektursignalen und

FIG 3 zeigt ausschnittsweise eine für eine adaptive Einstellung von Korrektursignal-Koeffizienten verwendbare Schaltungsanordnung.

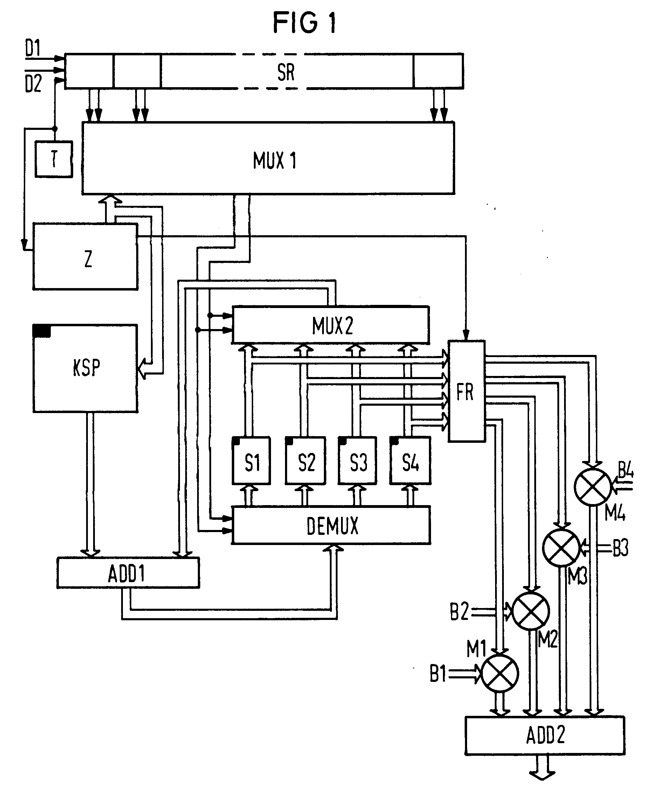

FIG 1 zeigt ein Ausführungsbeispiel einer Schaltungsanordnung zur Erzeugung von Korrektursignalen für die Übertragung von mehrwertigen Digitalsignalen. Bei diesen möge es sich beispielsweise um nach einem sogenannten "2B1Q"-Code codierte vierwertige Digitalsignale handeln, die mit einer Übertragungsgeschwindigkeit von 80 kBaud zu übertragen sind. Derartige Digitalsignale können vier unterschiedliche Amplitudenwerte - 3, - 1, + 1, + 3 annehmen. Diese vierwertigen Digitalsignale werden dabei der in FIG 1 dargestellten Schaltungsanordnung binär codiert zugeführt, d. h. jeder zu übertragende Amplitudenwert wird durch zwei Bits dargestellt. Ein Bit gibt dabei z. B. die Amplitude und das verbleibende Bit das Vorzeichen an.

Die gerade genannten binär codierten Datensignale werden einer Schieberegisteranordnung SR zugeführt, welche die die einzelnen Amplitudenwerte der Datensignale angebenden zwei Bits parallel aufnimmt. Diese Schieberegisteranordnung, welche von einem Taktgenerator T entsprechend der vorgesehenen Übertragungsgeschwindigkeit 80-kHz-Taktimpulse zugeführt erhält, möge beispielsweise 48 Register aufweisen, d. h. für die Bildung eines Korrektursignals werden 48 aufeinanderfolgende Datensignale berücksichtigt.

Jedes der genannten Register weist zwei parallele, die beiden einen Amplitudenwert charakterisierenden Bits führende Ausgänge auf. Die beiden Ausgänge sämtlicher Register sind jeweils einem Eingang einer Multiplex-Anordnung MUX1 zugeführt, d. h. die Multiplex-Anordnung weist insgesamt 48 jeweils zwei Bits führende Eingänge auf. Diese Multiplex-Anordnung ist mit Steuereingängen über ein aus sechs parallelen Leitungen bestehendes Leitungssystem mit einer Zähleranordnung Z verbunden. Es handelt sich hierbei um eine freilaufende Binärzähleranordnung, deren Zählperiode 48 beträgt und deren Zählerstände über das genannte Leitungssystem als Adressensignale der Multiplex-Anordnung MUX1 zugeführt werden. Entsprechend dieser fortlaufend bereitgestellten Adressensignale werden die in den Registern der Schieberegisteranordnung SR binär codierten Amplitudenwerte im Zeitmultiplex an einem Ausgang der Multiplex-Anordnung MUX1 bereitgestellt.

Mit dem genannten Leitungssystem sind außerdem Adresseneingänge einer Koeffizienten-Speicheranordnung KSP mit insgesamt 48 Speicherzellen verbunden. In diesen Speicherzellen sind den einzelnen Registern der Schieberegisteranordnung SR zugeordnete Korrektursignal-Koeffizienten gespeichert, die jeweils beispielsweise 20 Bits umfassen mögen. Der Ausgang dieser Koeffizienten-Speicheranordnung ist mit einem Eingang eines Summierers ADD1 verbunden. Ein zweiter Eingang dieses Summierers ist an einen Ausgang einer weiteren Multiplex-Anordnung MUX2 angeschlossen. Diese weist vier Eingänge auf, an welche jeweils über ein Leitungssystem ein Teilsummen-Speicher mit seinem Ausgang angeschlossen ist. Diese Teilsummen-Speicher tragen die Bezeichnung S1 bis S4. Ein Eingang jedes der Teilsummen-Speicher ist über ein weiteres Leitungssystem an einen Ausgang einer insgesamt vier Ausgänge aufweisenden Demultiplex-Anordnung DEMUX angeschlossen. Der Eingang dieser Demultiplex-Anordnung steht mit dem Ausgang des bereits genannten Summierers ADD1 in Verbindung.

Die Multiplex-Anordnung MUX2 und die Demultiplex-Anordnung DEMUX sind an Steuereingängen mit den an dem Ausgang der bereits erwähnten Multiplex-Anordnung MUX1 im Zeitmultiplex auftretenden binär codierten Amplitudenwerten beaufschlagt. Diese Amplitudenwerte dienen dabei als Adressensignale für die Auswahl der einzelnen Teilsummen-Speicher S1 bis S4.

Die mit den Ausgängen der Teilsummen-Speicher S1 bis S4 verbundenen Leitungssysteme sind zusätzlich an eine Freigabeeinrichtung FR herangeführt. Diese Freigabeeinrichtung, die beispielsweise aus UND-Gliedern gebildet sein möge, ist von der Zähleranordnung Z her durch Abgabe eines Steuersignals derart steuerbar, daß sie am Ende einer Zählperiode der Zähleranordnung die Ausgänge der Teilsummen-Speicher S1 bis S4 gleichzeitig mit jeweils einem Multiplizierer verbindet. Diese Multiplizierer sind mit M1 bis M4 bezeichnet. Die Ziffern geben dabei die Zuordnung zu den Teilsummen-Speichern S1 bis S4 an. Die Multiplizierer sind außerdem jeweils mit einer Konstanten, auf die im folgenden noch näher eingegangen wird, beaufschlagt. Die Konstanten sind dabei entsprechend ihrer Zugehörigkeit zu den einzelnen Multiplizierern mit B1 bis B4 bezeichnet. Die Ausgangssignale dieser Multiplizierer sind einem Summierer ADD2 zugeführt, der diese Signale zu einem Summensignal aufsummiert.

Die zuvor erwähnten Teilsummen-Speicher S1 bis S4 bilden im übrigen zusammen mit dem Summierer ADD1 vier individuelle Akkumulatoren, auf deren Verwendung im folgenden noch eingegangen wird.

Nachdem zuvor die in FIG 1 dargestellte Schaltungsanordnung beschrieben worden ist, wird nunmehr auf deren Wirkungsweise näher eingegangen.

Wie bereits oben erwähnt, dient die in FIG 1 dargestellte Schaltungsanordnung zur Erzeugung von Korrektursignalen, mit deren Hilfe Echosignale bei einer Duplex-Übertragung von mehrwertigen Datensignalen, im vorliegenden Ausführungsbeispiel vierwertigen Datensignalen, kompensiert werden. Derartige Echosignale lassen sich in bekannter Weise durch folgende Gleichung angeben.

$$ y_E \; (kT) = \sum_{n=0}^{N-1} A_{k-n} \cdot h_E \; (nT) \quad , \qquad\qquad (1) $$

wobei $y_E$ (kT) ein Echosignal zum Zeitpunkt kT, $A_{k-n}$ den momentanen Amplitudenwert eines Datensignals zum Zeitpunkt (k-n) T, $h_E$ (nT) die Echoimpulsantwort zum Zeitpunkt nT und N die Anzahl der Anteile an einem Echosignal liefernden, aufeinanderfolgenden Datensignale angeben.

Für eine Kompensation eines nach Gleichung (1) gebildeten Echosignals ist ein Korrektursignal der Form

$$ y_K \; (kT) = \sum_{n=0}^{N-1} A_{k-n} \cdot C_n \qquad\qquad (2) $$

erforderlich. Dabei stellen $C_n$ Korrektursignal-Koeffizienten dar. Wie sich aus einem Vergleich der Gleichungen (1) und (2) ergibt, ist eine vollständige Kompensation eines Echosignals möglich, wenn $C_n = h_E$ (nT) ist.

Die Gleichung (2) läßt sich in W Teilsummen zerlegen.

$$ y_K = A1 \sum_{n=0}^{N-1} d1 \; (k-n) \cdot C_n + \dots + Aw \sum_{n=0}^{N-1} dw \; (k-n) \cdot C_n \qquad (3) $$

$$ \text{mit} \quad d1 \; (k-n) \; = \begin{cases} 1 & , \; \text{wenn } A_{k-n} = A1 \\ 0 & \quad \text{sonst} \end{cases} $$

$$ \vdots $$

$$ dw \; (k-n) \; = \begin{cases} 1 & , \; \text{wenn } A_{k-n} = Aw \\ 0 & \quad \text{sonst} \end{cases} $$

A1 bis Aw stellen dabei die möglichen Amplitudenwerte der zu übertragenden Datensignale dar. Gemäß Gleichung (3) werden also aus den für die einzelnen Amplitudenwerte A1 bis Aw zu berücksichtigenden Korrektursignal-Koeffizienten Teilsummen gebildet und mit dem jeweiligen Amplitudenwert multipliziert. Daraus resultieren w Teil-Korrektursignale, die zu einem Gesamt-Korrektursignal aufsummiert werden.

Von der in FIG 1 dargestellten Schaltungsanordnung werden Korrektursignale gemäß Gleichung (3) erzeugt. Dabei wird, wie bereits oben erwähnt, davon ausgegangen, daß die zu übertragenden Datensignale gemäß einer "2B1Q"-Codierung vier Amplitudenwerte, nämlich -1, -3, +1, +3, annehmen können und mit einer Übertragungsgeschwindigkeit von 80 kBaud übertragen werden. Außerdem sei angenommen, daß insgesamt 48 aufeinanderfolgende Datensignale Anteile an einem Echosignal liefern und somit für die Bildung eines Korrektursignals zu berücksichtigen sind.

Die vierwertigen Datensignale werden mit einem 80-kHz-Takt in die Schieberegisteranordnung SR übernommen. Die Inhalte der Register dieser Schieberegisteranordnung werden dabei in einem der gewählten Übertragungsgeschwindigkeit entsprechenden Zeitintervall von 12,5 $\mu$s nacheinander von der Multiplex-Anordnung MUX1 abgerufen, die dazu von der Zähleranordnung Z entsprechende Adressensignale zugeführt erhält. Am Ausgang dieser MultiplexAnordnung treten somit im Zuge eines Abfragezyklus im Zeitmultiplex nacheinander die in den einzelnen Registern gespeicherten binär codierten 48 Amplitudenwerte auf.

Mit den von der Zähleranordnung Z abgegebenen Adressensignalen wird gleichzeitig die Koeffizienten-Speicheranordnung KSP beaufschlagt, so daß mit jeder Auswahl eines Registers der Schieberegisteranordnung SR ein diesem zugeordneter Korrektursignal-Koeffizient Cn bereitgestellt ist. Die somit nacheinander am Ausgang der Koeffizienten-Speicheranordnung auftretenden 48 Korrektursignal-Koeffizienten werden gemäß Gleichung (3) nach Maßgabe der am Ausgang der Multiplex-Anordnung MUX1 auftretenden Amplitudenwerte vier den Amplitudenwerten individuell zugeordneten Akkumulatoren zugeführt, die aus den ihnen jeweils zugeführten Korrektursignal-Koeffizienten Teilsummen bilden. Diese Akkumulatoren sind, wie bereits oben erwähnt, jeweils aus einem Teilsummen-Speicher (in FIG 1 mit S1 bis S4 bezeichnet) und dem allen Akkumulatoren gemeinsamen Summierer ADD1 gebildet. Die Teilsummen-Speicher sind im übrigen von der Zähleranordnung Z her derart steuerbar, daß deren Speicherinhalte zu Beginn einer Zählperiode der Zähleranordnung gelöscht werden.

Die Auswahl der einzelnen für die bereitgestellten Korrektursignal-Koeffizienten jeweils in Frage kommenden Akkumulatoren erfolgt mit Hilfe der gleichzeitig mit den Korrektursignal-Koeffizienten am Ausgang der Multiplex-Anordnung MUX1 auftretenden Amplitudenwerte, die der Multiplex-Anordnung MUX2 und der Demultiplex-Anordnung DEMUX als Adressensignale zugeführt sind. Auf diese Adressierungen hin geben die jeweils ausgewählten Teilsummen-Speicher die in ihnen jeweils bis dahin gespeicherte Teilsumme über die Multiplex-Anordnung MUX2 an den Summierer ADD1 ab, der zu der jeweiligen Teilsummen den gerade von der Koeffizienten-Speicheranordnung KSP bereitgestellten Korrektursignal-Koeffizienten addiert. Anschließend wird die neugebildete Teilsumme über die Demultiplex-Anordnung DEMUX in den jeweils in Frage kommenden Teilsummen-Speicher übernommen. Dabei wird die bis dahin gespeicherte Teilsumme überschrieben. Nach Ablauf einer Zählperiode der Zähleranordnung Z, d. h. nach Abruf sämtlicher in den 48 Registern der Schieberegisteranordnung SR gespeicherten Amplitudenwerte, wird die Freigabeeinrichtung FR auf ein von der Zähleranordnung Z abgegebenes Steuersignal hin freigegeben. Damit werden die in den Teilsummen-Speichern S1 bis S4 gespeicherten Teilsummen den Multiplizierern M1 bis M4 zugeführt. Diese Multiplizierer, die jeweils einem Akkumulator und damit einem bestimmten Amplitudenwert zugeordnet sind, multiplizieren die ihnen zugeführte Teilsumme jeweils mit einer Konstanten (in FIG 1 mit B1 bis B4 bezeichnet), die dem jeweils zugeordneten Amplitudenwert entspricht. Bei dem hier beschriebenen Ausführungsbeispiel sind also die Konstanten B1 bis B4 mit -1, -3, +1, +3 festgelegt.

Die an den Ausgängen der Multiplizierer M1 bis M4 auftretenden Signale stellen gemäß Gleichung (3) Teil-Korrektursignale dar, die dem Summierer ADD2 für die Bildung eines Gesamt-Korrektursignals zugeführt werden.

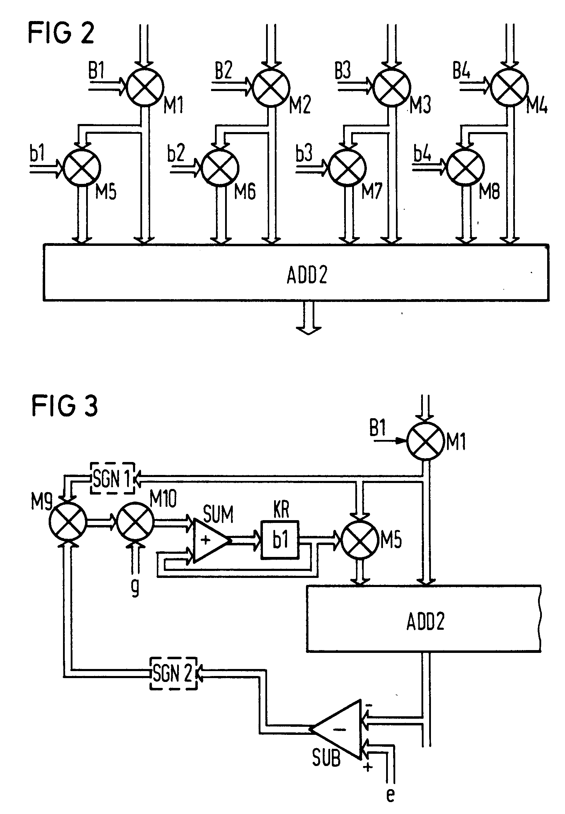

Vorstehend wurde davon ausgegangen, daß die Amplitudenwerte der Datensignale den Sollwerten -1, -3, +1, +3 entsprechen. Es kann jedoch auch der Fall eintreten, daß Abweichungen vom Sollwert zumindest bei einem Teil der Amplitudenwerte auftreten. Derartige Abweichungen können beispielsweise durch an der Übertragung von Datensignalen beteiligte Übertragungseinrichtungen hervorgerufen werden. Aus solchen Abweichungen resultieren unsymmetrische Echosignale. Um auch derartige Echosignale kompensieren zu können, kann die in FIG 1 angegebene Schaltungsanordnung, wie in FIG 2 dargestellt, erweitert werden. In FIG 2 sind dabei lediglich die Multiplizierer M1 bis M4 und der diesen nachgeschaltete Summierer ADD2 der Schaltungsanordnung gemäß FIG 1 dargestellt. Wie aus FIG 2 hervorgeht, sind die an den Ausgängen der Multiplizierer M1 bis M4 auftretenden Teil-Korrektursignale zusätzlich jeweils einem weiteren Multiplizierer zugeführt. Diese weiteren Multiplizierer sind mit M5 bis M8 bezeichnet. Jeder dieser Multiplizierer ist zusätzlich mit einem Zusatz-Korrektursignal-Koeffizienten beaufschlagt. Diese Zusatz-Korrektursignal-Koeffizienten sind mit den Bezeichnungen b1 bis b4 versehen.

Die am Ausgang der Multiplizierer M5 bis M8 auftretenden korrigierten Teil-Korrektursignale werden zusammen mit den von den Multiplizierern M1 bis M4 abgegebenen Teil-Korrektursignalen dem Summierer ADD2 für die Bildung eines Gesamt-Korrektursignals zugeführt. Damit ergibt sich als Gesamt-Korrektursignal

$$y_K = \sum_{n=1}^{4} K_n + \sum_{n=1}^{4} b_n K_n \qquad (5)$$

Wobei $K_n$ die an den Ausgängen der Multiplizierer M1 bis M4 auftretenden Teil-Korrektursignale darstellen.

Die zuvor erwähnten Zusatz-Korrektursignal-Koeffizienten b1 bis b4 können jeweils adaptiv einstellbar sein. Eine solche Einstellung kann beispielsweise in der Form

$$b_i \text{ (neu)} = b_i \text{ (alt)} + g \cdot D \cdot K_i$$

vorgenommen werden. Hierbei bedeuten $b_i$ den jeweils einzustellenden Zusatz-Korrektursignal-Koeffizienten, g eine Konstante, Ki das dem jeweiligen Zusatz-Korrektursignal-Koeffizienten zugeordnete Teil-Korrektursignal und D die Differenz zwischen dem gerade erzeugten Korrektursignal und einem mit diesem korrigierten empfangenen Datensignal e. Eine für eine derartige adaptive Einstellung geeignete Schaltungsanordnung ist in FIG 3 am Beispiels des Zusatz-Korrektursignal-Koeffizienten b1 dargestellt. Diese Schaltungsanordnung weist einen Subtrahierer SUB auf, dem das gerade erzeugte Korrektursignal und das Signal e zugeführt sind. Der Ausgang dieses Summierers ist mit einem Multiplizierer M9 verbunden, der zusätzlich das von dem Multiplizierer M1 abgegebene Teil-Korrektursignal zugeführt erhält. Mit dem Ausgangssignal dieses Multiplizierers M9 ist ein weiterer Multiplizierer M10 beaufschlagt, der das ihm zugeführte Signal mit der Konstanten g multipliziert. Das daraus resultierende Produktsignal wird einem Eingang eines Summierers SUM 1 zugeführt. An einem zweiten Eingang wird dieser Summierer mit dem in einer Speicheranordnung KR, beispielsweise in einer Registerzelle, gespeicherten Zusatz-Korrektursignal-Koeffizienten b1 (alt) beaufschlagt. Am Ausgang des Summierers SUM1 tritt somit der aktualisierte Zusatz-Korrektursignal-Koeffizient b1 (neu) auf, der in die Speicheranordnung KR unter Überschreiben des bishin darin gespeicherten Zusatz-Korrektursignal-Koeffizienten b1 (alt) übernommen wird. Dieser neue Zusatz-Korrektursignal-Koeffizient ist dem Multiplizierer M5 für die Bildung eines weiteren Korrektursignals zugeführt.

Im übrigen sei darauf hingewiesen, daß die in FIG 3 ausschnittweise dargestellte Schaltungsanordnung für die adaptive Einstellung der Zusatz-Korrektursignal-Koeffizienten auch derart ausgebildet werden kann, daß für die Aktualisierung des Zusatz-Korrektursignal-Koeffizienten b1 der Multiplizierer M9 nicht das von dem Multiplizierer M1 abgegebene Teil-Korrektursignal und das von dem Subtrahierer SUB bereitgestellte Differenzsignal zugeführt erhält, sondern lediglich das Vorzeichen der genannten Signale. In diesem Falle ist den Eingängen des Multiplizierers M9 jeweils eine Schaltungsanordnung zur Vorzeichenermittlung vorgeschaltet. Diese Schaltungsanordnungen sind in FIG 3 mit SGN1 und SGN2 bezeichnet.

Die in FIG 1 dargestellte Schaltungsanordnung kann für den Fall, daß die Amplitudenwerte der zu übertragenden vierwertigen Datensignale vorzeichensymmetrisch sind, vereinfacht werden. In diesem Fall sind nämlich lediglich die Teilsummen für die Amplitudenwerte ± 1, ± 3 in zwei Teilsummen-Speichern zu erfassen, wenn anstelle des Summierers ADD1 eine Anordnung benutzt ist, die in Abhängigkeit von den Vorzeichen der am Ausgang der Multiplex-Anordnung MUX1 auftretenden Amplitudenwerte eine Addition bzw. Subtraktion durchführt.

Im übrigen kann auch die Anzahl der in FIG 3 dargestellten Multiplizierer M5 bis M8 reduziert werden, falls lediglich ein Teil der Amplitudenwerte von den Sollwerten abweicht.

Vorstehend wurde zwar anhand der FIG 1 bis 3 lediglich die Erzeugung von Korrektursignalen bei einer Übertragung von vierwertigen Datensignalen erläutert. Die beschriebene Schaltungsanordnung kann aber auch für die Übertragung beliebiger mehrwertiger Datensignale durch das Vorsehen einer entsprechenden Anzahl von Teilsummen-Speichern und diesen nachgeschalteten Multiplizierern angepaßt werden. Im übrigen kann für die Erzeugung von Korrektursignalen gemäß Gleichung (3) anstelle der anhand der FIG 1 bis 3 erläuterten Schaltungsanordnung auch eine Mikroprozessor-Anordnung benutzt sein.

Abschließend sei noch darauf hingewiesen, daß zwar vorstehend das Verfahren und die Schaltungsanordnung gemäß der vorliegenden Erfindung am Beispiel der Erzeugung von der Kompensation von Echosignalen dienenden Korrektursignalen erläutert worden ist. Das beschriebene Verfahren und die nach diesem Verfahren arbeitende Schaltungsanordnung sind aber allgemein für Filterstrukturen zur Erzeugung von Filtersignalen geeignet. Als Beispiel seien hier Filtersignale genannt, welche in entscheidungs-rückgekoppelten Entzerrern zur Entzerrung empfangener mehrwertiger Datensignale dienen.

**Patentansprüche**

1. Verfahren zur Erzeugung von Filtersignalen nach Art eines Transversalfilters, welchem W unterschiedliche Amplitudenwerte annehmende Datensignale als Eingangssignale zugeführt und in welchem in einer N Speicherzellen aufweisenden Durchlauf-Speicheranordnung N aufeinanderfolgende Eingangssignale gespeichert werden, wobei
nach Maßgabe der in den Speicherzellen der Durchlauf-Speicheranordnung gespeicherten Eingangssignale zunächst für die W möglichen Amplitudenwerte individuell die in Frage kommenden Filtersignal-Koeffizienten aufsummiert und W entsprechende Teilsummensignale bereitgestellt werden, die Teilsummensignale anschließend jeweils mit einem dem jeweiligen Amplitudenwert entsprechenden Faktor multipliziert und die daraus resultierenden Produktsignale zu einem Summensignal aufsummiert werden,
**dadurch gekennzeichnet**,
daß wenigstens ein Teil der Produktsignale jeweils mit einem dem jeweiligen Amplitudenwert zugeordneten Zusatz-Korrektursignal-Koeffizienten multipliziert wird
und daß die daraus resultierenden Zusatz-Produktsignale in die Bildung des Summensignale miteinbezogen werden.

2. Verfahren nach Anspruch 1, **dadurch gekennzeichnet,**
daß die Zusatz-Korrektursignal-Koeffizienten jeweils auf die Bildung eines Korrektursignals hin adaptiv nach Maßgabe des gerade vorliegenden zugehörigen Produktsignals und des durch das gerade gebildete Korrektursignal korrigierten empfangenen Datensignals eingestellt werden.

3. Verfahren nach Anspruch 1 oder 2, **dadurch gekennzeichnet,**
daß als Filtersignale Korrektursignale erzeugt werden, welche bei einer über eine Zweidrahtleitung erfolgenden Duplexübertragung von mehrwertigen Datensignalen für die Unterdrückung von zusammen mit empfangenen Datensignalen auftretenden Echosignalen dienen.

4. Schaltungsanordnung zur Erzeugung von Korrektursignalen nach Art eines Transversalfilters, welche bei einer Übertragung von Datensignalen, die W verschiedene Amplitudenwerte annehmen können, zur Unterdrückung von zusammen mit empfangenen Datensignalen auftretenden Echosignalen bzw. zur Entzerrung von empfangenen Datensignalen dienen, mit einer N Speicherzellen aufweisenden Durchlauf-Speicheranordnung (SR) für die Speicherung von N aufeinanderfolgenden Datensignalen, mit einer Koeffizienten-Speicheranordnung (KSP), in welcher den N Speicherzellen zugeordnete Korrektursignal-Koeffizienten gespeichert sind, und mit einer Akkumulatoranordnung, die eine den möglichen W Amplitudenwerten der Datensignale entsprechende Anzahl von Akkumulatoren (S1,...,S4, ADD1) aufweist, welche nach Maßgabe der in den Speicherzellen der Durchlauf-Speicheranordnung (SR) gespeicherten Datensignale jeweils lediglich die für den jeweiligen Amplitudenwert in Frage kommenden Korrektursignal-Koeffizienten aufsummieren und ein entsprechendes Teilsummensignal bereitstellen, wobei jedem der Akkumulatoren ein Multiplizierer (M1....M4) nachgeschaltet ist, welcher das ihm jeweils zugeführte Teilsummensignal mit einem dem jeweiligen Amplitudenwert entsprechenden Faktor multipliziert und ein daraus resultierendes Produktsignal bereitstellt und wobei die von den einzelnen Multiplizierern bereitgestellten Produktsignale einem Summierer (ADD2) zugeführt sind, welcher diese aufsummiert und ein entsprechendes Summensignal bereitstellt, **dadurch gekennzeichnet,**
daß wenigstens einem Teil der Multiplizierer jeweils ein weiterer Multiplizierer (M5,....M8) nachgeschaltet ist, welcher das von dem zugehörigen vorgeschalteten Multiplizierer abgegebene Produktsignal mit einem dem jeweiligen Amplitudenwert zugeordneten Zusatz-Korrektursignal-Koeffizienten multipliziert,
und daß die von den weiteren Multiplizierern bereitgestellten Zusatz-Produktsignale zusätzlich dem Summierer (ADD2) für die Bildung des Summensignals zugeführt sind.

5. Schaltungsanordnung nach Anspruch 4, **dadurch gekennzeichnet,** daß jedem der weiteren Multiplizierer (M5,...M8) eine Einrichtung (SUM1, SUM2, M9, M10, KR) für die adaptive Einstellung des jeweiligen Zusatz-Korrektursignal-Koeffizientenzugeordnet ist, welche auf die Bildung eines Korrektursignals hin den jeweiligen Zusatz-Korrektursignal-Koeffizienten nach Maßgabe des dem zugeordneten weiteren Multiplizierer zuvor zugeführten Produktsignals und des durch das gerade gebildete Korrektursignal korrigierten empfangenen Datensignals aktualisiert.

**6.** Schaltungsanordnung nach Anspruch 4 oder 5, **dadurch gekennzeichnet,**

daß die Durchlauf-Speicheranordnung aus einer Schieberegisteranordnung (SR) mit N Registern gebildet ist, in welchen die Amplitudenwerte der Datensignale binär codiert gespeichert sind, daß eine Steuereinrichtung (MUX1, Z) vorgesehen ist, welche im Zuge eines Abfragezyklus einerseits nacheinander die N Register für eine Abfrage des jeweils gespeicherten Amplitudenwertes und andererseits die Koeffizienten-Speicheranordnung (KSP) für eine Abgabe des dem jeweiligen Register zugeordneten Korrektursignal-Koeffizienten ansteuert,

daß auf die Abgabe eines Korrektursignal-Koeffizienten hin anhand des zusammen mit diesem bereitgestellten Amplitudenwertes der diesem zugeordnete Akkumulator für eine Übernahme des jeweiligen Korrektursignal-Koeffizienten aktiviert ist

und daß mit den Akkumulatoren eine Freigabeeinrichtung (FR) verbunden ist, welche auf ein von der Steuereinrichtung (MUX1, Z) abgegebenes, das Ende eines Abfragezyklus anzeigendes Steuersignal hin die von den Akkumulatoren gebildeten Teilsummensignale an die jeweils in Frage kommenden Multiplizierer abgibt.

**7.** Schaltungsanordnung nach Anspruch 6, **dadurch gekennzeichnet,**

daß die Akkumulatoren jeweils aus einem individuellen Teilsummen-Speicher (S1,...,S4) und einem sämtlichen Akkumulatoren gemeinsamen Summierer (ADD1) gebildet sind, daß der Summierer mit einem seiner Eingänge über eine Multiplex-Anordnung (MUX2) mit den Ausgängen der Teilsummen-Speicher und mit seinem Ausgang über eine Demultiplex-Anordnung (DEMUX) mit den Eingängen der Teilsummen-Speicher verbindbar ist,

daß der zweite Eingang des Summierers mit den von der Koeffizienten-Speicheranordnung (KSP) bereitgestellten Korrektursignal-Koeffizienten beaufschlagt ist

und daß die Mulitplex-Anordnung und die Demultiplex-Anordnung für ihre Steuerung die im Zuge eines Abfragezyklus abgefragten Amplitudenwerte zugeführt erhalten.

**8.** Schaltungsanordnung nach Anspruch 7, welcher vierwertige binär codierte Datensignale zugeführt sind, von deren möglichen Amplitudenwerten jeweils zwei zu einem vorgegebenen Referenzwert symmetrisch liegen und sich lediglich im Vorzeichen unterscheiden, **dadurch gekennzeichnet,**

daß lediglich zwei den betragsmäßig voneinander abweichenden Amplitudenwerten zugeordnete Teilsummen-Speicher (z. B. S1, S2) vorgesehen sind,

daß der Summierer (ADD1) nach Maßgabe der in den binär codierten Amplitudenwerten enthaltenen Vorzeicheninformationen eine Addition bzw. Subtraktion ausführt

und daß lediglich für einen der zwei betragsmäßig voneinander abweichenden Amplitudenwerten ein Zusatz-Korrektursignal-Koeffizient in die Bildung eines Summensignals einbezogen ist.

**Claims**

**1.** Method for generating filter signals in the manner of a transversal filter to which data signals assuming W different amplitude values are supplied as input signals and in which N successive input signals are stored in a transit storage arrangement having N storage cells, it being the case that in accordance with the input signals stored in the storage cells of the transit storage arrangement the filter signal coefficients concerned are firstly individually summed up for the W possible amplitude values and W corresponding partial sum signals are made available, and the partial sum signals are subsequently respectively multiplied by a factor corresponding to the respective amplitude value and the product signals resulting therefrom are summed up to form an aggregate signal, characterised in that at least some of the product signals are respectively multiplied by an additional correction signal coefficient assigned to the respective amplitude value, and in that the additional product signals resulting therefrom are also included in the formation of the aggregate signal.

**2.** Method according to Claim 1, characterised in that the additional correction signal coefficients are set adaptively in each case upon the formation of a correction signal in accordance with the associated product signal just present and with the received data signal corrected by the correction signal just formed.

**3.** Method according to Claim 1 or 2, characterised in that as correction signals filter signals are generated which in the case of duplex transmission of multi-value data signals performed via a two-wire line serve to suppress echo signals occurring together with received data signals.

4. Circuit arrangement for generating correction signals in the manner of a transversal filter, which in the case of transmission of data signals which can assume W different amplitude values serve to suppress echo signals occurring together with received data signals or to equalise received data signals, comprising a transit storage arrangement (SR), having N storage cells, for storing N successive data signals, comprising a coefficient storage arrangement (KSP) in which correction signal coefficients assigned to the N storage cells are stored, and comprising an accumulator arrangement which has a number, corresponding to the possible W amplitude values of the data signals, of accumulators (S1,...,S4, ADD1) which in accordance with the data signals stored in the storage cells of the transit storage arrangement (SR) in each case sum up only the correction signal coefficients concerned for the respective amplitude value and make available a corresponding partial sum signal, there being connected downstream of each of the accumulators a multiplier (M1...M4) which multiplies the partial sum signal assigned to it in each case by a factor corresponding to the respective amplitude value and makes available a product signal resulting therefrom, and the product signals made available by the individual multipliers being supplied to a summer (ADD2) which sums up said product signals and makes available a corresponding aggregate signal, characterised in that there is respectively connected downstream of at least some of the multipliers a further multiplier (M5,...,M8) which multiplies the product signal transmitted by the associated upstream multiplier by an additional correction signal coefficient assigned to the respective amplitude value, and in that the additional product signals made available by the further multipliers are additionally supplied to the summer (ADD2) for forming the aggregate signal.

5. Circuit arrangement according to Claim 4, characterised in that each of the further multipliers (M5,...,M8) is assigned a device (SUM1, SUM2, M9, M10, KR) for adaptively setting the respective additional correction signal coefficient, which device upon the formation of a correction signal updates the respective additional correction signal coefficient in accordance with the product signal previously supplied to the assigned further multiplier and with the received data signal corrected by the correction signal just formed.

6. Circuit arrangement according to Claim 4 or 5, characterised in that the transit storage arrangement is formed from a shift register arrangement (SR) having N registers in which the amplitude values of the data signals are stored in binary code, in that a control device (MUX1, Z) is provided which in the course of an interrogation cycle successively drives the N registers to interrogate the respectively stored amplitude value, on the one hand, and drives the coefficient storage arrangement (KSP) to transmit the correction signal coefficient assigned to the respective register, on the other hand, in that upon the transmission of a correction signal coefficient and with the aid of the amplitude value made available together therewith the accumulator assigned thereto is activated for transfer of the respective correction signal coefficient, and in that there is connected to the accumulators a release device (FR) which upon a control signal transmitted by the control device (MUX1, Z) and indicating the end of an interrogation cycle transmits to the multiplier respectively concerned the partial sum signals formed by the accumulators.

7. Circuit arrangement according to Claim 6, characterised in that the accumulators are respectively formed from an individual partial sum memory (S1,...,S4) and a summer (ADD1) common to all accumulators, in that the summer can be connected with one of its inputs via a multiplex arrangement (MUX2) to the outputs of the partial sum memories, and with its output via a demultiplex arrangement (DEMUX) to the inputs of the partial sum memories, in that the correction signal coefficients made available by the coefficient storage arrangement (KSP) is applied to the second input of the summer, and in that the multiplex arrangement and the demultiplex arrangement are supplied for their control to the amplitude values interrogated in the course of an interrogation cycle.

8. Circuit arrangement according to Claim 7, to which there are supplied four-valued data signals in binary code, of the possible amplitude values of which in each case two are situated symmetrically with respect to a prescribed reference value and differ only in sign, characterised in that there are provided only two partial sum memories (for example, S1, S2) assigned to the amplitude values, which deviate from one another in amount, in that the summer (ADD1) executes an addition or subtraction in accordance with the sign information contained in the amplitude values in binary code, and in that an additional correction signal coefficient is also included in the formation of an aggregate signal only for one of the two amplitude values deviating from one another in amount.

**Revendications**

1. Procédé pour produire des signaux filtrés, à la manière d'un filtre transversal, auquel des signaux de données, qui prennent W valeurs d'amplitude différentes, sont envoyés en tant que signaux d'entrée et dans lequel N signaux d'entrée successifs sont mémorisés dans un dispositif de mémoire circulante possédant N cellules de mémoire, et dans lequel

   en fonction des signaux d'entrée mémorisés dans les cellules de mémoire du dispositif de mémoire circulante, les coefficients des signaux filtrés entrant en jeu sont additionnés individuellement tout d'abord pour les W valeurs d'amplitude possibles, et W signaux de sommes partielles correspondants sont préparés, les signaux de sommes partielles sont ensuite multipliés respectivement par un facteur qui correspond à la valeur d'amplitude respective, et les signaux de produits, qui en résultent, sont additionnés pour former un signal somme,

   caractérisé par le fait

   qu'au moins une partie des signaux de produits est multipliée respectivement par un coefficient de signal de correction supplémentaire associé à la valeur d'amplitude respective, et que les signaux de produits supplémentaires, qui en résultent, sont utilisés lors de la formation du signal somme.

2. Procédé suivant la revendication 1, caractérisé par le fait que les coefficients de signaux de correction supplémentaires sont réglés respectivement sur la formation d'un signal de correction, d'une manière adaptative en fonction du signal de produit associé respectivement présent et du signal de données reçu, corrigé par le signal de correction précisément formé.

3. Procédé suivant la revendication 1 ou 2, caractérisé par le fait qu'on forme, comme signaux filtrés, des signaux de correction, qui, dans le cas d'une transmission duplex, exécutée par l'intermédiaire d'une ligne bifilaire, de signaux de données à plusieurs valeurs sont utilisés pour supprimer des signaux d'échos qui apparaissent conjointement avec des signaux de données reçus.

4. Montage pour produire, à la manière d'un filtre transversal, des signaux de correction, qui, dans le cas d'une transmission de signaux de données qui peuvent prendre W valeurs différentes d'amplitude, servent à supprimer des signaux d'échos apparaissant conjointement avec des signaux de données reçus ou à éliminer les déformations de signaux de données reçus, comportant un dispositif de mémoire circulante (SR) comprenant N cellules de mémoire, pour la mémorisation de N signaux de données successifs, un dispositif de mémoire de coefficients (KSP), dans lequel sont mémorisés des coefficients du signal de correction associés aux N cellules de mémoire, et un dispositif à accumulateurs, qui possède un nombre, qui correspond aux W valeurs possibles des signaux de données, d'accumulateurs (S1,...,S4; ADD1), qui, en fonction des signaux de données mémorisés dans les cellules de mémoire du dispositif de mémoire circulante (SR), additionnent respectivement seulement les coefficients des signaux de correction, qui entrent en jeu pour la valeur d'amplitude respective, et préparent un signal correspondant de somme partielle, et dans lequel en aval de chacun des accumulateurs est branché un multiplicateur (M1...M4), qui multiplie le signal de somme partielle, qui lui est respectivement envoyé, par un facteur qui correspond à la valeur d'amplitude respective, et prépare un signal de produit, qui résulte de cette multiplication, et dans lequel les signaux de produit préparés par les différents multiplicateurs, sont envoyés à un additionneur (ADD2), qui les additionne et prépare un signal somme correspondant, caractérisé par le fait qu'en aval d'au moins une partie des multiplicateurs est branché respectivement un autre multiplicateur (M5,...,M8), qui multiplie le signal de produit délivré par le multiplicateur amont associé, par un coefficient de signal de correction supplémentaire, qui est associé à la valeur d'amplitude respective, et que les signaux de produits supplémentaires préparés par les autres multiplicateurs sont envoyés en outre à l'additionneur (ADD2) pour la formation du signal somme.

5. Montage suivant la revendication 4, caractérisé par le fait qu'à chacun des autres multiplicateurs (M5, ..., M8) est associé un dispositif (SUM1, SUM2, M9, M10, KR) pour le réglage adaptatif du coefficient respectif du signal de correction supplémentaire, ce dispositif actualisant, lors de la formation d'un signal de correction, le coefficient respectif du signal de correction supplémentaire en fonction du signal de produit envoyé antérieurement à l'autre multiplicateur associé, et du signal de données reçu, corrigé par le signal de correction précisément formé.

**6.** Montage suivant la revendication 4 ou 5, caractérisé par le fait

que le dispositif de mémoire circulante est formée par un dispositif à registres à décalage (SR) comportant N registres, dans lesquels les valeurs d'amplitude des signaux de données sont mémorisées d'une manière codée en binaire, qu'il est prévu un dispositif de commande (MUX1, Z), qui, au cours d'un cycle d'interrogation, commande d'une part successivement les N registres pour une interrogation de la valeur d'amplitude respectivement mémorisée et d'autre part commande le dispositif de mémoire de coefficients (KSP) pour une délivrance du coefficient du signal de correction associé au registre respectif,

que, lors de la délivrance d'un coefficient du signal de correction, il se produit, sur la base de la valeur d'amplitude préparée conjointement avec ce coefficient, une activation de l'accumulateur, associé à cette valeur d'amplitude, pour un transfert du coefficient respectif du signal de correction, et

qu'aux accumulateurs est raccordé un dispositif de libération (FR), qui, lors de l'apparition d'un signal de commande délivré par le dispositif de commande (MUX1, Z) et qui indique la fin d'un cycle d'interrogation, envoie les signaux de sommes partielles, formés par les accumulateurs, aux multiplicateurs qui entrent respectivement en jeu.

**7.** Montage suivant la revendication 6, caractérisé par le fait

que les accumulateurs sont formés chacun par une mémoire individuelle de somme partielle (S1...S4) et par un additionneur (ADD1) commun à tous les accumulateurs, que l'additionneur peut être racccordé, par l'une de ses entrées, par l'intermédiaire d'un dispositif de multiplexage (MUX2), aux sorties des mémoires de sommes partielles et, par sa sortie, par l'intermédiaire d'un dispositif de démultiplexage (DEMUX), aux entrées de la mémoire de sommes partielles,

que la seconde entrée de l'additionneur est chargée par le coefficient du signal de correction, qui est préparé par le dispositif de mémoire de coefficients (KSP), et

que le dispositif de multiplexage et le dispositif de démultiplexage reçoivent, pour leur commande, les valeurs d'amplitude interrogées au cours d'un cycle d'interrogation.

**8.** Montage suivant la revendication 7, auquel sont envoyés des signaux de données codés en binaire et possédant quatre valeurs, et dont deux des valeurs d'amplitude respectives possibles sont symétriques par rapport à une valeur de référence prédéterminée et diffèrent uniquement par le signe, caractérisé par le fait

qu'il est prévu seulement deux mémoires de sommes partielles (par exemple S1, S2) associées aux valeurs d'amplitude, dont les valeurs absolues diffèrent,

que l'additionneur (ADD1) exécute une addition ou une soustraction en fonction des informations de signes contenues dans les valeurs d'amplitude codées en binaire, et

qu'un coefficient du signal de correction supplémentaire est utilisé lors de la formation d'un signal somme, uniquement pour l'une des deux valeurs d'amplitude dont les valeurs absolues diffèrent.

FIG 1

FIG 2

FIG 3